(19) **Europäisches Patentamt**
**European Patent Office**
**Office européen des brevets**

(11) **EP 4 782 804 A1**

(12) **EUROPEAN PATENT APPLICATION**

(43) Date of publication:
 **29.07.2026 Bulletin 2026/31**

(21) Application number: **26152971.3**

(22) Date of filing: **20.01.2026**

(51) International Patent Classification (IPC):
 **G01K 7/01** (2006.01) **G01K 15/00** (2006.01)

(52) Cooperative Patent Classification (CPC):
 **G01K 7/01; G01K 15/005; G05F 1/46; G05F 1/567;
 G06F 17/00; G06F 17/10; H03M 1/06; H03M 1/10;**
 G01D 18/00; G01K 2219/00

(84) Designated Contracting States:
 **AL AT BE BG CH CY CZ DE DK EE ES FI FR GB
 GR HR HU IE IS IT LI LT LU LV MC ME MK MT NL
 NO PL PT RO RS SE SI SK SM TR**
 Designated Extension States:
 **BA**
 Designated Validation States:
 **GE KH LA MA MD TN**

(30) Priority: **22.01.2025 KR 20250009625
 27.06.2025 KR 20250085881**

(71) Applicant: **LX Semicon Co., Ltd.
 Daejeon 34027 (KR)**

(72) Inventors:
 • **CHOI, Ho Yul**
  **Daejeon (KR)**
 • **LEE, Sun Ju**
  **Daejeon (KR)**
 • **YUN, Jin Kook**
  **Daejeon (KR)**
 • **YUN, Il Hyun**
  **Daejeon (KR)**

(74) Representative: **Goddar, Heinz J.
 Boehmert & Boehmert
 Anwaltspartnerschaft mbB
 Pettenkoferstrasse 22
 80336 München (DE)**

(54) **TEMPERATURE SENSOR MODULE AND TEMPERATURE COMPENSATION METHOD THEREOF**

(57) A temperature sensor module and a temperature compensation method thereof according to embodiments of the present disclosure are disclosed. The temperature sensor module includes a temperature sensor configured to output a voltage value corresponding to a sensed temperature; a control circuit configured to calculate a first compensation value based on a code value for the voltage value using reference code values at a first temperature and a second temperature higher than the first temperature, and calculate a second compensation value using an average trend line determined as an average value for each temperature in a first temperature interval equal to or lower than the first temperature and a second temperature interval equal to or higher than the second temperature; a 1st compensation circuit configured to apply the first compensation value to the code value to generate a first-stage compensated first code value; and a 2nd compensation circuit configured to apply the second compensation value to the generated first code value to generate a second-stage compensated second code value.

# FIG. 1

**Description**

CROSS-REFERENCE TO RELATED APPLICATION

This application claims priority to and the benefit of Korean Patent Application No. 10-2025-0009625, filed January, 22, 2025, and Korean Patent Application No. 10-2025-0085881, filed June, 27, 2025, the disclosure of which is incorporated herein by reference in its entirety.

BACKGROUND

**Field**

Embodiments of the present disclosure relate to a temperature sensor module and a temperature compensation method thereof.

**Discussion of Related Art**

Generally, a temperature sensor may be implemented using a semiconductor element such as a bipolar junction transistor (BJT) or a metal-oxide-semiconductor field-effect transistor (MOSFET), a resistive element such as a thermistor, or a thermoelectric element. In order to implement a temperature sensor having high temperature precision, a compensation scheme based on two points has been applied.

However, although this compensation scheme provides high temperature precision in a temperature interval between the two points, a significant temperature error may occur in other temperature intervals depending on process conditions.

In order to reduce the temperature error, a multi-point or high-order compensation scheme is required. However, implementing such a scheme in hardware or software requires a large amount of resources.

If the temperature precision deteriorates, the mass productivity of the temperature sensor decreases. Therefore, there is a need for various compensation schemes capable of implementing high temperature precision while being simple.

SUMMARY

An object of the present disclosure is to solve the above-described necessity and/or problem.

Embodiments of the present disclosure may provide a temperature sensor module capable of being implemented with high temperature precision, and a temperature compensation method thereof.

The problems of the present disclosure are not limited to those mentioned above, and other problems not mentioned herein will be clearly understood by those skilled in the art from the following description.

A temperature sensor module according to an embodiment of the present disclosure may include a temperature sensor configured to output a voltage value corresponding to a sensed temperature; a control circuit configured to calculate a first compensation value based on a code value for the voltage value using reference code values at a first temperature and a second temperature higher than the first temperature, and calculate a second compensation value using an average trend line determined as an average value for each temperature in a first temperature interval equal to or lower than the first temperature and a second temperature interval equal to or higher than the second temperature; a 1st compensation circuit configured to apply the first compensation value to the code value to generate a first-stage compensated first code value; and a 2nd compensation circuit configured to apply the second compensation value to the generated first code value to generate a second-stage compensated second code value.

The first compensation value may include a first offset and a first gain value, and the 1st compensation circuit may add the first offset to the code value to generate a first-stage calculated code value, and may generate the first code value based on a second-stage calculated code value obtained by multiplying the first-stage calculated code value by the first gain value.

The 1st compensation circuit may generate, as the first code value, a code value having a predetermined number of bits by removing at least one lower bit from the second-stage calculated code value.

The second compensation value may include a second offset and a second gain value for the first temperature interval or the second temperature interval, and the 2nd compensation circuit may add the second offset to the first code value to generate a first-stage calculated first code value, and may generate the second code value based on a second-stage calculated first code value obtained by multiplying the first-stage calculated first code value by the second gain value.

The 2nd compensation circuit may generate, as the second code value, a first code value having a predetermined number of bits by removing at least one lower bit from the second-stage calculated first code value.

The 2nd compensation circuit may subtract the second offset from the generated first code value having the predetermined number of bits to generate a third-stage calculated first code value as the second code value.

The second offset may include a reference code value at the first temperature at which the first temperature interval starts and a reference code value at the second temperature at which the second temperature interval starts, and the second gain value may include a reciprocal of a slope of the average trend line in the first temperature interval and a reciprocal of a slope of the average trend line in the second temperature interval.

A temperature compensation method of a temperature sensor module may include outputting a voltage value corresponding to a sensed temperature; calculating a first compensation value based on a code value for the voltage value using reference code values at a first temperature and a second temperature higher than the first temperature, and calculating a second compensation value using an average trend line determined as an average value for each temperature in a first temperature interval equal to or lower than the first temperature and a second temperature interval equal to or higher than the second temperature; generating a first-stage compensated first code value by applying the first compensation value to the code value; and generating a second-stage compensated second code value by applying the second compensation value to the generated first code value. Any one, some or all of the features disclosed herein with respect to a compensation circuit may also be implemented in the temperature compensation method, unless indicated otherwise or technically inappropriate. Any one, some or all of the features disclosed herein with respect to the temperature compensation method may also be implemented in the compensation circuit, unless indicated otherwise or technically inappropriate. The temperature compensation method may be configured to be carried out, at least partly, using the compensation circuit disclosed herein. The compensation circuit may be configured to perform, at least a part of, the temperature compensation method disclosed herein.

The first compensation value includes a first offset and a first gain value, and in said generating the first code value, the first offset may be added to the code value to generate a first-stage calculated code value, and the first code value may be generated based on a second-stage calculated code value obtained by multiplying the first-stage calculated code value by the first gain value.

In said generating the first code value, a code value having a predetermined number of bits may be generated as the first code value by removing at least one lower bit from the second-stage calculated code value.

The second compensation value may include a second offset and a second gain value for the first temperature interval or the second temperature interval, and in said generating the second code value, the second offset may be added to the first code value to generate a first-stage calculated first code value, and the second code value may be generated based on a second-stage calculated first code value obtained by multiplying the first-stage calculated first code value by the second gain value.

In said generating the second code value, a first code value having a predetermined number of bits may be generated as the second code value by removing at least one lower bit from the second-stage calculated first code value, and the second offset may be subtracted from the generated first code value having the predetermined number of bits to generate a third-stage calculated first code value as the second code value.

According to the present disclosure, a code value corresponding to a temperature measured using the temperature sensor may be compensated in a first stage using a two-point compensation scheme, and may be compensated in a second stage using the average trend line determined as the average value for each temperature in the first temperature interval and the second temperature interval, thereby implementing high temperature precision. Accordingly, mass productivity of the temperature sensor may be improved.

The effects of the present disclosure are not limited to those mentioned above, and other effects not mentioned herein will be clearly understood by those skilled in the art from the description of the claims.

BRIEF DESCRIPTION OF THE DRAWINGS

The above and other objects, features, and advantages of the present disclosure will become more apparent to those of ordinary skill in the art by describing exemplary embodiments thereof in detail with reference to the attached drawings, in which:

FIG. 1 is a diagram illustrating a temperature sensor module according to an embodiment of the present disclosure;
FIGS. 2 and 3 are diagrams illustrating a temperature compensation principle according to an embodiment of the present disclosure;
FIG. 4 is a diagram illustrating a detailed configuration of the 1st compensation circuit shown in FIG. 1;
FIG. 5 is a diagram illustrating a detailed configuration of the 2nd compensation circuit shown in FIG. 1; and
FIG. 6 is a diagram illustrating a temperature compensation method according to an embodiment of the present disclosure.

DETAILED DESCRIPTION OF EXEMPLARY EMBODIMENTS

The advantages and features of the present disclosure, and methods of achieving them will be apparent from the embodiments described in detail below in conjunction with the accompanying drawings. The present invention is not limited to the following embodiments, which may be implemented in various different forms; rather, the present embodiments are provided to make the disclosure of the present invention complete and to allow those skilled in the art to fully understand the scope of the present invention, and the present invention is defined only within the scope of the appended claims.

The shapes, sizes, proportions, angles, numbers and the like shown in the accompanying drawings for the purpose of describing the embodiments of the present disclosure are merely examples, and the present disclosure is not limited thereto. Like reference numerals generally denote like elements throughout the present specification. Further, in describing the present disclosure, detailed descriptions of known related technologies may be omitted so as not to unnecessarily obscure the subject matter of the present disclosure.

The terms such as "comprising," "including," "having," and "consisting of" used herein are generally intended to allow other components to be added unless the terms are used with the term "only." References to the singular shall be construed to include the plural unless expressly stated otherwise.

In the interpretation of components, they are construed to include margins of error, even if not explicitly stated.

When describing a positional or interconnected relationship between two components, such as "on top of," "above," "below," "next to," "connect or couple with," "crossing," "intersecting," etc., one or more other components may be interposed between them unless "immediately" or "directly" is used.

When describing a temporal contextual relationship, such as "after," "following," "next to," or "before," it may not be continuous on a time scale unless "immediately" or "directly" is used.

First, second, and the like may be used before the names of the components to distinguish the components, but the function or structure thereof is not limited by such ordinal number or component name. For ease of description, the ordinal numbers placed before the names of the same components may differ between embodiments.

The following embodiments may be combined or associated with each other in whole or in part, and various types of interlocking and driving are technically possible. The embodiments may be implemented independently of one another or may be implemented together in an interrelated relationship.

Hereinafter, various embodiments of the present disclosure will be described in detail with reference to the accompanying drawings.

In an embodiment, a temperature compensation scheme is proposed in which a code value corresponding to a temperature measured using a temperature sensor is compensated in a first stage using a two-point compensation scheme, and is compensated in a second stage using an average trend line determined by an average value for each temperature in a first temperature interval and a second temperature interval.

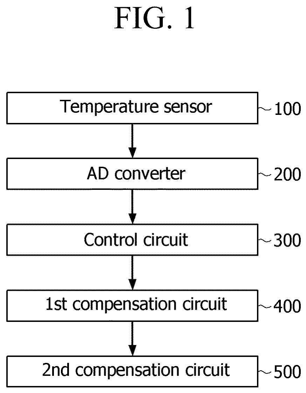

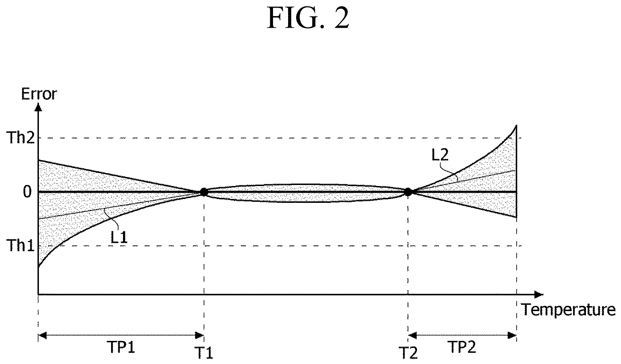

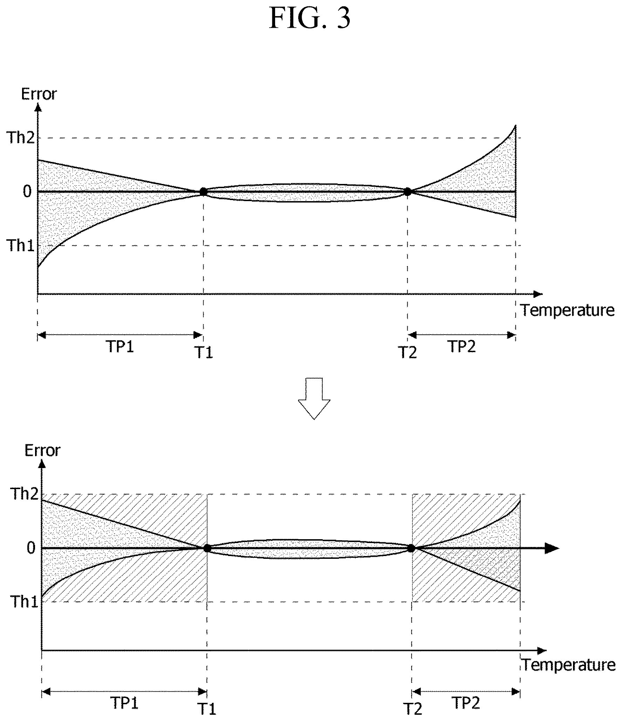

FIG. 1 is a diagram illustrating a temperature sensor module according to an embodiment of the present disclosure, and FIGS. 2 and 3 are diagrams illustrating a temperature compensation principle according to an embodiment of the present disclosure.

Referring to FIG. 1, the temperature sensor module according to an embodiment of the present disclosure may include a temperature sensor 100, an analog-to-digital (AD) converter 200, a control circuit 300, a 1st compensation circuit 400, and a 2nd compensation circuit 500.

The temperature sensor 100 may measure a temperature and generate an analog voltage value corresponding to the measured temperature. For example, the temperature sensor 100 may include a bipolar junction transistor (BJT). The temperature sensor 100 may generate a voltage value corresponding to the temperature by using characteristics of the BJT in which a potential difference between a base and an emitter varies according to temperature.

The AD converter 200 may convert the generated analog voltage value into a digital value and generate a code value of a predetermined number of bits.

The control circuit 300 may calculate a first compensation value based on the generated code value. The first compensation value may include a first offset and a first gain value, but is not limited thereto.

The control circuit 300 may calculate the first offset based on the generated code value. For example, the control circuit 300 may calculate the first offset based on the code value and a reference value determined according to the temperature.

In this case, the first offset Offset1 may be obtained as shown in Equation 1 below.

[Equation 1]

$$Offset1 = \dfrac{\dfrac{Ideal\_value1 \times Real\_value2 - Ideal\_value2 \times Real\_vlaue1}{Real\_value2 - Real\_value1}}{Gain1}$$

Here, Real_value1 is a temperature value or a code value measured at a first temperature, and Real_value2 is a temperature value or a code value measured at a second temperature higher than the first temperature. Ideal_value1 and Ideal _value2 are reference code values corresponding to predetermined ideal temperatures, where Ideal_value1 is a reference code value at the first temperature and Ideal _value2 is a reference code value at the second temperature.

For example, as illustrated in FIG. 2, the first temperature T1 may be set to 30°C and the second temperature T2 may be set to 85°C, but they are not limited thereto.

The control circuit 300 may calculate the first gain value based on the generated code value. For example, the control circuit 300 may calculate the first gain value based on the code value and a reference code value determined according to the temperature.

In this case, the first gain value Gain1 may be obtained as shown in Equation 2 below.

[Equation 2]

$$Gain1 = (Ideal\_value2 - Ideal\_value1) / (Real\_value2 - Real\_value1)$$

The control circuit 300 may calculate a second compensation value based on a predetermined average trend line. The second compensation value may include a second offset and a second gain value.

As illustrated in FIG. 2, hatched portions represent errors calculated based on actually measured temperatures. First and second average trend lines L1 and L2 are predetermined in a first temperature interval TP1 and a second temperature interval TP2 where the error deviates from a lower limit threshold Th1 or an upper limit threshold Th2. The first average trend line L1 is an average value of the errors calculated based on the temperatures measured in the first temperature interval TP1. The second average trend line L2 is an average value of the errors calculated based on the temperatures measured in the second temperature interval TP2.

The control circuit 300 may calculate the second offset and the second gain value for the first temperature interval TP1 based on the first average trend line L1 in the first temperature interval TP1 as shown in FIG. 2, and may calculate the second offset and the second gain value for the second temperature interval TP2 based on the second average trend line L2 in the second temperature interval TP2. Here, the second offset may include a reciprocal of a slope of the first average trend line L1 and a reciprocal of a slope of the second average trend line L2. The second gain value may include the reference code value at the first temperature T1 where the first average trend line L1 starts in the first temperature interval TP1, and the reference code value at the second temperature T2 where the second average trend line L2 starts in the second temperature interval TP2.

To explain in detail, in the first temperature interval TP1 and the second temperature interval TP2, since an error between the reference code value and the measured code value falls outside an allowable error range, a compensation value is calculated, and the measured code value is compensated with the calculated compensation value.

On the other hand, no compensation value is calculated in an interval between the first temperature interval TP1 and the second temperature interval TP2. This is because, in the interval between the first temperature interval TP1 and the second temperature interval TP2, an error in the measured code value can be compensated using only the first-stage compensation.

The 1st compensation circuit 400 may apply the calculated first compensation value to an input code value to generate a first-stage compensated first code value.

The 2nd compensation circuit 500 may apply the second compensation value calculated in a predetermined temperature interval to the first code value to generate a second-stage compensated second code value as a final code value.

In this case, referring to FIG. 3, when only the first-stage compensation is performed, the error falls outside the allowable error range in the first temperature interval TP1 and the second temperature interval TP2. In contrast, when the first-stage compensation and the second-stage compensation are performed as in the embodiment, the error does not fall outside the allowable error range in an interval between the first temperature interval TP1 and the second temperature interval TP2. The allowable error range may be a range between the lower limit threshold Th1 and the upper limit threshold Th2.

As described above, in the embodiment, high temperature precision of the temperature sensor may be implemented through the first-stage compensation and the second-stage compensation, thereby improving the mass productivity of the temperature sensor.

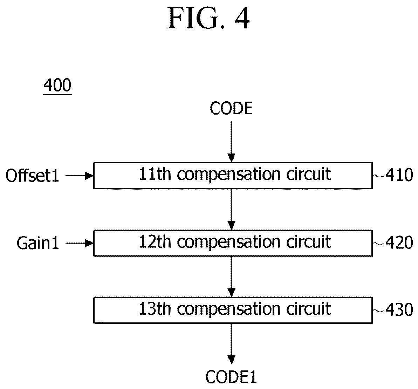

FIG. 4 is a diagram illustrating a detailed configuration of the 1st compensation circuit shown in FIG. 1.

Referring to FIG. 4, the 1st compensation circuit 400 according to an embodiment of the present disclosure may include an 11th compensation circuit 410, a 12th compensation circuit 420, and a 13th compensation circuit 430.

The 11th compensation circuit 410 may apply the calculated first offset to the code value. For example, the 11th compensation circuit 410 may be implemented as an adder. The 11th compensation circuit 410 may add the calculated first offset to the code value to generate a first-stage calculated code value.

The 12th compensation circuit 420 may apply the calculated first gain value to the first-stage calculated code value. For example, the 12th compensation circuit 420 may be implemented as a multiplier. The 12th compensation circuit 420 may multiply the first-stage calculated code value by the calculated first gain value to generate a second-stage calculated code value.

The 13th compensation circuit 430 may generate the first code value based on the second-stage calculated code value. For example, the 13th compensation circuit 430 may shift the second-stage calculated code value in a predetermined direction to generate the first code value having a predetermined number of bits.

For example, when the code value inputted to the 11th compensation circuit 410 is 10 bits, and is calculated in the first stage in the 11th compensation circuit 410 and calculated in the second stage in the 12th compensation circuit 420 to become a 12-bit code value, the 12-bit code value is shifted to be converted into a 10-bit first code value.

In this case, when the 12-bit code value is shifted in a predetermined direction in the 13th compensation circuit 430, the lower 2 bits are removed, thereby generating the 10-bit first code value.

The 10-bit first code value generated in this manner may be expressed as shown in Equation 3 below.

[Equation 3]

$$CODE1 = (CODE + Offset1) \times Gain1$$

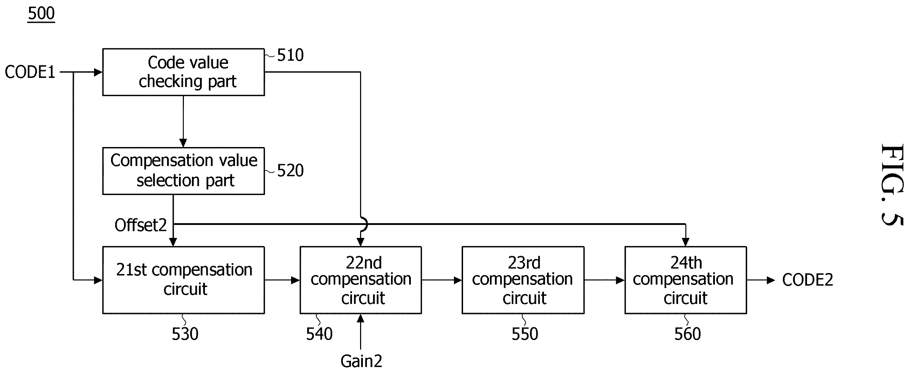

FIG. 5 is a diagram illustrating a detailed configuration of the 2nd compensation circuit shown in FIG. 1.

Referring to FIG. 5, the 2nd compensation circuit 500 according to an embodiment of the present disclosure may include a code value checking part 510, a compensation value selection part 520, a 21st compensation circuit 530, a 22nd compensation circuit 540, a 23rd compensation circuit 550, and a 24th compensation circuit 560.

The code value checking part 510 may check a temperature interval of the generated first code value. The code value checking part 510 may check whether the first code value exists in the first temperature interval or the second temperature interval.

When the first code value does not exist in the first temperature interval or the second temperature interval but exists in an interval between the first temperature interval and the second temperature interval, the code value checking part 510 may output the first code value as the second code value without additional compensation of the first code value.

When the first code value exists in the first temperature interval or the second temperature interval, the code value checking part 510 may generate an identifier for identifying the first temperature interval or the second temperature interval. The identifier may be transmitted to the compensation value selection part 520 and the 22nd compensation circuit 540.

The compensation value selection part 520 may select the second compensation value for the first temperature interval or the second temperature interval based on the identifier. The second compensation value may include a second offset Offset2 and a second gain value Gain2 for the first temperature interval or the second temperature interval.

The compensation value selection part 520 may select the second compensation value for the first temperature interval or the second temperature interval based on the identifier, and may transmit the selected second compensation value to the 21st compensation circuit 530 and the 24th compensation circuit 560.

The 21st compensation circuit 530 may apply the second offset to the first code value to generate a first-stage calculated first code value. The 21st compensation circuit 530 may be implemented as an adder. The 21st compensation circuit 530 may add the second offset to the first code value to generate the first-stage calculated first code value.

The 22nd compensation circuit 540 may apply the second gain value for the first temperature interval or the second temperature interval to the first-stage calculated first code value to generate a second-stage calculated first code value.

The 22nd compensation circuit 540 may select the second gain value for the first temperature interval or the second temperature interval based on the identifier transmitted from the code value checking part 510, and apply the selected second gain value to the first-stage calculated first code value. The 22nd compensation circuit 540 may be implemented as a multiplier. The 22nd compensation circuit 540 may multiply the first-stage calculated first code value by the selected second gain value to generate the second-stage calculated first code value.

The 23rd compensation circuit 550 may generate a third-stage calculated first code value based on the second-stage calculated first code value. For example, the 23rd compensation circuit 550 may shift the second-stage calculated first code value in a predetermined direction to generate the first code value having a predetermined number of bits.

For example, when the code value inputted to the 21st compensation circuit 530 is 10 bits, and is calculated in the first stage in the 21st compensation circuit 530 and calculated in the second stage in the 22nd compensation circuit 540 to become a 12-bit code value, the 12-bit code value is shifted to be converted into a 10-bit first code value.

In this case, when the 12-bit code value is shifted in a predetermined direction in the 23rd compensation circuit 550, the lower 2 bits are removed, thereby generating the 10-bit first code value.

The 24th compensation circuit 560 may apply the second offset for the first temperature interval or the second temperature interval to the third-stage calculated first code value to generate a finally calculated second code value.

The 24th compensation circuit 560 may select the second offset for the first temperature interval or the second temperature interval based on the identifier transmitted from the code value checking part 510, and apply the selected second offset to the third-stage calculated first code value. The 24th compensation circuit 560 may be implemented as a subtractor. The 24th compensation circuit 560 may subtract the selected second offset from the third-stage calculated first code value to generate the finally calculated second code value.

The finally calculated second code value may be expressed as shown in Equation 4 and Equation 5 below.

[Equation 4]

$$CODE2 = Gain2\_T2 \times (CODE1 + Offset2\_T2) - Offset2\_T2, \text{ if } T2$$

[Equation 5]

$$CODE2 = Gain2\_T1 \times (CODE1 + Offset2\_T1) - Offset2\_T1, \text{ if } T1$$

Here, Gain2_T2 is the second gain value for the second temperature interval, Offset2_T2 is the second offset for the second temperature interval, Gain2_T1 is the second gain value for the first temperature interval, and Offset2_T1 is the second offset for the first temperature interval.

As shown in Equation 4 and Equation 5, when the second offset is added to the first code value and the second gain value is multiplied thereafter, the first code value at the corresponding temperature may rapidly increase or decrease to become a discontinuous point, so the second offset is subtracted once more.

In this case, code values of the second offset included in the first temperature interval have negative values, and code values of the second offset included in the second temperature interval have positive values. Accordingly, values excluding signs of the code values included in the first temperature interval and the code values included in the second temperature interval, that is, absolute values, are used for calculation.

For example, when having a code value of -932 for 30°C included in the first temperature interval TP1 and a code value of 112 for 85°C included in the second temperature interval TP2, Equation 4 and Equation 5 may be re-expressed as Equation 6 and Equation 7 below.

[Equation 6]

$$CODE2 = Gain2\_T2 \times (CODE1 + 112) - 112$$

[Equation 7]

$$CODE2 = Gain2\_T1 \times (CODE1 + 932) - 932$$

In addition, when the code values included in the first temperature interval and the second temperature interval are used as they are, the 21st compensation circuit 530 and the 24th compensation circuit 560 may be implemented as different circuits.

As an example, when the code values for the first temperature interval TP1 are applied as they are, the 21st compensation circuit 530 may be implemented as a subtractor, and the 24th compensation circuit 560 may be implemented as an adder.

As another example, when the code values for the second temperature interval TP2 are applied as they are, the 21st compensation circuit 530 may be implemented as an adder, and the 24th compensation circuit 560 may be implemented as a subtractor.

Accordingly, the 21st compensation circuit 530 and the 24th compensation circuit 560 may be implemented to include both a subtractor and an adder, and an operation processing circuit may vary according to the temperature interval.

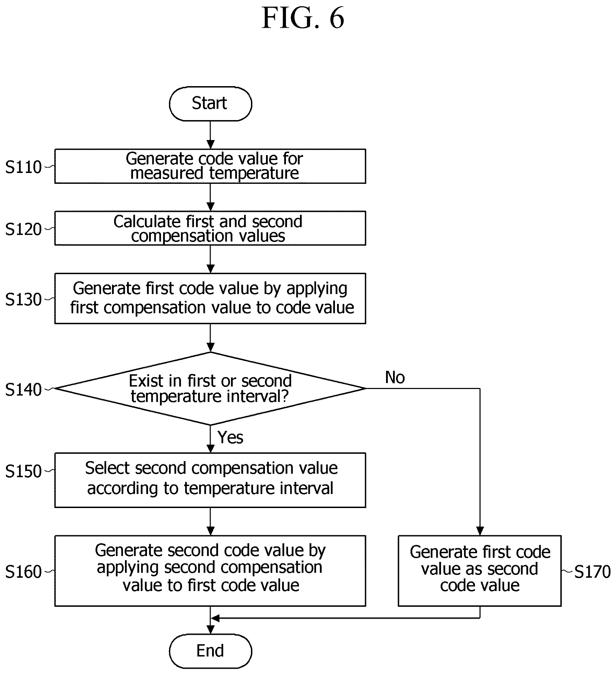

FIG. 6 is a diagram illustrating a temperature compensation method according to an embodiment of the present disclosure.

Referring to FIG. 6, the temperature sensor module according to an embodiment of the present disclosure may generate an analog voltage value corresponding to a temperature, and convert the generated analog voltage value into a digital value to generate a code value (step S110).

Next, the temperature sensor module may calculate the first compensation value and the second compensation value based on the code value (step S120). The first compensation value may include the first offset and the first gain value, and the second compensation value may include the second offset and the second gain value.

Next, the temperature sensor module may apply the first offset to the code value to generate a first-stage calculated code value, and apply the first gain value to the first-stage calculated code value to generate a second-stage calculated code value as the first code value (step S130).

In this case, the temperature sensor module may shift the second-stage calculated code value to remove at least one lower bit, thereby generating the first code value having a predetermined number of bits.

Next, the temperature sensor module may check whether the first code value exists in the first temperature interval or the second temperature interval (step S140).

Next, when the first code value exists in the first temperature interval or the second temperature interval, the temperature sensor module may select the second compensation value according to the temperature interval (step S150).

Next, when the first code value exists in the first temperature interval, the temperature sensor module may apply the second offset for the first temperature interval to the first code value to generate a first-stage calculated first code value, and apply the second gain value for the first temperature interval to the first-stage calculated first code value to generate a second-stage calculated first code value as the finally calculated second code value (step S160).

In this case, the temperature sensor module may shift the second-stage calculated first code value to generate a third-stage calculated first code value, and apply the second offset for the first temperature interval to the third-stage calculated first code value to generate a fourth-stage calculated code value as the finally calculated second code value.

In addition, when the first code value exists in the second temperature interval, the temperature sensor module may apply the second offset for the second temperature interval to the first code value to generate a first-stage calculated first code value, and apply the second gain value for the second temperature interval to the first-stage calculated first code value to generate a second-stage calculated first code value as the finally calculated second code value (step S160).

In this case, the temperature sensor module may shift the second-stage calculated first code value to generate a third-stage calculated first code value, and apply the second offset for the second temperature interval to the third-stage calculated first code value to generate a fourth-stage calculated code value as the finally calculated second code value.

On the other hand, when the first code value does not exist in the first temperature interval or the second temperature interval, the temperature sensor module may generate the first code value as the second code value without additional compensation for the first code value (step S170).

Although the embodiments of the present invention have been described in more detail with reference to the accompanying drawings, they are not necessarily limited to such embodiments, and may be modified in various ways within its scope without departing from the technical spirit of the present invention. Therefore, the embodiments disclosed in the present specification are provided for illustrative purposes only and are not intended to limit the technical concept of the present disclosure, and the scope of the technical concept of the present disclosure is not limited to these embodiments. Therefore, it should be understood that the embodiments described above are illustrative in all aspects and do not limit the present disclosure. The scope of protection of the present invention should be construed on the basis of the following claims, and all technical concepts within the equivalent scope thereof should be construed as falling within the scope of the present invention.

**Claims**

1. A temperature sensor module, comprising:

   a temperature sensor configured to output a voltage value corresponding to a sensed temperature;
   a control circuit configured to calculate a first compensation value based on a code value for the voltage value using reference code values at a first temperature and a second temperature higher than the first temperature, and calculate a second compensation value using an average trend line determined as an average value for each temperature in a first temperature interval equal to or lower than the first temperature and a second temperature interval equal to or higher than the second temperature;
   a 1st compensation circuit configured to apply the first compensation value to the code value to generate a first-stage compensated first code value; and

a 2nd compensation circuit configured to apply the second compensation value to the generated first code value to generate a second-stage compensated second code value.

2. The temperature sensor module of claim 1, wherein the first compensation value includes a first offset and a first gain value, and

the 1st compensation circuit adds the first offset to the code value to generate a first-stage calculated code value, and generates the first code value based on a second-stage calculated code value obtained by multiplying the first-stage calculated code value by the first gain value.

3. The temperature sensor module of claim 2, wherein the 1st compensation circuit generates, as the first code value, a code value having a predetermined number of bits by removing at least one lower bit from the second-stage calculated code value.

4. The temperature sensor module of any one of the preceding claims, wherein the second compensation value includes a second offset and a second gain value for the first temperature interval or the second temperature interval, and

the 2nd compensation circuit adds the second offset to the first code value to generate a first-stage calculated first code value, and generates the second code value based on a second-stage calculated first code value obtained by multiplying the first-stage calculated first code value by the second gain value.

5. The temperature sensor module of claim 4, wherein the second offset includes a reference code value at the first temperature at which the first temperature interval starts and a reference code value at the second temperature at which the second temperature interval starts, and

the second gain value includes a reciprocal of a slope of the average trend line in the first temperature interval and a reciprocal of a slope of the average trend line in the second temperature interval.

6. The temperature sensor module of claim 4 or 5, wherein the 2nd compensation circuit generates, as the second code value, a first code value having a predetermined number of bits by removing at least one lower bit from the second-stage calculated first code value.

7. The temperature sensor module of claim 6, wherein the 2nd compensation circuit subtracts the second offset from the generated first code value having the predetermined number of bits to generate a third-stage calculated first code value as the second code value.

8. The temperature sensor module of any one of claims 4 to 7, wherein the 2nd compensation circuit performs a calculation using an absolute value that excludes a sign of the second offset.

9. The temperature sensor module of any one of the preceding claims, wherein when the first code value does not exist in the first temperature interval or the second temperature interval but exists in a temperature interval between the first temperature interval and the second temperature interval, the 2nd compensation circuit generates the first code value as the second code value without compensating the first code value.

10. A temperature compensation method of a temperature sensor module, comprising:

outputting a voltage value corresponding to a sensed temperature;

calculating a first compensation value based on a code value for the voltage value using reference code values at a first temperature and a second temperature higher than the first temperature, and calculating a second compensation value using an average trend line determined as an average value for each temperature in a first temperature interval equal to or lower than the first temperature and a second temperature interval equal to or higher than the second temperature;

generating a first-stage compensated first code value by applying the first compensation value to the code value; and

generating a second-stage compensated second code value by applying the second compensation value to the generated first code value.

11. The temperature compensation method of claim 10, wherein the first compensation value includes a first offset and a first gain value, and

in said generating the first code value, the first offset is added to the code value to generate a first-stage calculated code value, and the first code value is generated based on a second-stage calculated code value obtained by multiplying the first-stage calculated code value by the first gain value.

12. The temperature compensation method of claim 11, wherein in said generating the first code value, a code value having a predetermined number of bits is generated as the first code value by removing at least one lower bit from the second-stage calculated code value.

13. The temperature compensation method of any one of claims 10 to 12, wherein the second compensation value includes a second offset and a second gain value for the first temperature interval or the second temperature interval, and
in said generating the second code value, the second offset is added to the first code value to generate a first-stage calculated first code value, and the second code value is generated based on a second-stage calculated first code value obtained by multiplying the first-stage calculated first code value by the second gain value.

14. The temperature compensation method of claim 13, wherein in said generating the second code value, a first code value having a predetermined number of bits is generated as the second code value by removing at least one lower bit from the second-stage calculated first code value.

15. The temperature compensation method of claim 14, wherein in said generating the second code value, the second offset is subtracted from the generated first code value having the predetermined number of bits to generate a third-stage calculated first code value as the second code value.

FIG. 1

| Temperature sensor | ~100 |
| AD converter | ~200 |
| Control circuit | ~300 |
| 1st compensation circuit | ~400 |
| 2nd compensation circuit | ~500 |

# FIG. 2

# FIG. 3

# FIG. 4

400

CODE

Offset1 → | 11th compensation circuit | ~410

Gain1 → | 12th compensation circuit | ~420

| 13th compensation circuit | ~430

CODE1

# FIG. 5

500

CODE1

510 — Code value checking part

520 — Compensation value selection part

Offset2

530 — 21st compensation circuit

540 — 22nd compensation circuit

Gain2

550 — 23rd compensation circuit

560 — 24th compensation circuit

CODE2

# FIG. 6

```
                        ┌─────────┐
                        │  Start  │
                        └─────────┘
                             │
                             ▼
S110 ─┐  ┌──────────────────────────────────┐
      │  │    Generate code value for       │
         │      measured temperature        │
         └──────────────────────────────────┘
                             │
                             ▼
S120 ─┐  ┌──────────────────────────────────┐
      │  │     Calculate first and second    │
         │        compensation values        │
         └──────────────────────────────────┘
                             │
                             ▼
S130 ─┐  ┌──────────────────────────────────┐
      │  │  Generate first code value by applying │
         │  first compensation value to code value │
         └──────────────────────────────────┘
                             │
                             ▼
S140 ─┐ ◇────────────────────────────────◇        No
      │  │     Exist in first or second     │────────────┐
          │     temperature interval?       │            │
          ◇────────────────────────────────◇            │
                        │ Yes                             │
                        ▼                                 │
S150 ─┐  ┌──────────────────────────────────┐            │
      │  │   Select second compensation value │          │
         │    according to temperature interval │        │
         └──────────────────────────────────┘            │
                        │                                 │
                        ▼                                 ▼
S160 ─┐  ┌──────────────────────┐   ┌──────────────────────┐
      │  │ Generate second code value by │   │ Generate first code  │ ~S170
         │ applying second compensation  │   │  value as second     │
         │   value to first code value   │   │     code value       │
         └──────────────────────┘   └──────────────────────┘
                        │                                 │
                        ▼◄────────────────────────────────┘
                   ┌─────────┐
                   │   End   │
                   └─────────┘
```

## EUROPEAN SEARCH REPORT

**Application Number**

EP 26 15 2971

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2010/002591 A1 (ANALOG DEVICES INC [US]; BOSCH ENRIQUE COMPANY [ES] ET AL.) 7 January 2010 (2010-01-07) * paragraph [0014] - paragraph [0047]; figures 1-8 * | 1-15 | INV. G01K7/01 G01K15/00 |
| A | CN 116 989 916 A (CHENGDU DIANKE XINGTUO TECH CO LTD) 3 November 2023 (2023-11-03) * the whole document * | 1-15 | |
| A | WO 2024/104651 A1 (TRIDONIC GMBH & CO KG [AT]) 23 May 2024 (2024-05-23) * page 7, line 10 - page 19, line 22; figures 1-5 * | 1-15 | |

**TECHNICAL FIELDS SEARCHED (IPC)**

G01K

The present search report has been drawn up for all claims

| Place of search | Date of completion of the search | Examiner |
|---|---|---|
| The Hague | 2 June 2026 | Rosello Garcia, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 26 15 2971

This annex lists the patent family members relating to the patent documents cited in the above-mentioned European search report.
The members are as contained in the European Patent Office EDP file on
The European Patent Office is in no way liable for these particulars which are merely given for the purpose of information.

02-06-2026

| Patent document cited in search report | | Publication date | Patent family member(s) | | Publication date |
|---|---|---|---|---|---|
| WO 2010002591 | A1 | 07-01-2010 | CN | 102077067 A | 25-05-2011 |
| | | | EP | 2291624 A1 | 09-03-2011 |
| | | | JP | 2011527009 A | 20-10-2011 |
| | | | US | 2010002747 A1 | 07-01-2010 |
| | | | WO | 2010002591 A1 | 07-01-2010 |
| CN 116989916 | A | 03-11-2023 | NONE | | |
| WO 2024104651 | A1 | 23-05-2024 | EP | 4372342 A1 | 22-05-2024 |
| | | | WO | 2024104651 A1 | 23-05-2024 |

For more details about this annex : see Official Journal of the European Patent Office, No. 12/82

## REFERENCES CITED IN THE DESCRIPTION

**Patent documents cited in the description**

- KR 1020250009625
- KR 1020250085881